# EUROPEAN PATENT SPECIFICATION

(11) **EP 0 905 889 B1**
(45) Date of publication and mention of the grant of the patent: **30.11.2005**
(21) Application number: 97116968.5
(22) Date of filing: 30.09.1997
(51) Int. Cl.: H03H 17/06

(54) **Distributed decimation sample rate conversion**
Abtastratenumsetzung mit verteilter Dezimation
Convertisseur de la fréquence d'échantillonnage à décimation distribuée

(30) Priority: 30.09.1997 US 724168
(43) Date of publication of application: 31.03.1999
(73) Proprietor: Conexant Systems, Inc., Newport Beach, CA 92660 (US)
(72) Inventor: Rothacher, Fritz M., Newport Beach, CA 92663-5910 (US); Shamlou, Daryush, Laguna Niguel, California 92677 (US)
(74) Representative: Viering, Jentschura & Partner

(56) References cited:
- EP-A- 0 658 979
- US-A- 5 157 395
- KWENTUS A Y ET AL: "APPLICATION OF FILTER SHARPENING TO CASCADED INTEGRATOR-COMB DECIMATION FILTERS" IEEE TRANSACTIONS ON SIGNAL PROCESSING,US,IEEE, INC. NEW YORK, vol. 45, no. 2, 1 February 1997 (1997-02-01), pages 457-467, XP000722539 ISSN: 1053-587X
- SAMUELI H ET LIN T-J: "A VLSI ARCHITECTURE FOR A UNIVERSAL HIGH-SPEED MULTIRATE FIR DIGITAL FILTER WITH SELECTABLE POWER-OF-TWO DECIMATION/INTERPOLATION RATIOS" INTERNATIONAL CONFERENCE ON ACOUSTICS, SPEECH, AND SIGNAL PROCESSING ICASSP-91, vol. 3, 14 - 17 April 1991, pages 1813-1816, XP002167854

## Description

### FIELD OF THE INVENTION

The present invention is related to electronics circuits for converting data samples from one sample rate into data samples at another sample rate. More particularly, the invention is related to sample rate converters for high quality audio signal processing and conversion.

### ART BACKGROUND

With the progress in digital processing and communication technology, it is becoming quite common to digitize signals produced by analog sources for further processing in the digital domain, for storage in digital form, or for transmission through digital media. However, in the digital domain, there are different sampling rates used depending on the required quality and the available bandwidth. Thus, it has become important to have simple digital interfacing between different equipment and media.

The concept of sample rate conversion ("SRC") is well known to those who work with digital signals for multimedia applications. A conventional approach to the application of SRC is to first digitize some analog signals at a constant sample rate using an analog-to-digital converter ("ADC"). The digital signals are then applied to the SRC so that the converted signals will have a sample rate suitable for the intended purposes and applications. The SRC may have the following applications, as an example:

In order to transmit high-quality ("HQ") audio signals through a communications channel, e.g. phone line, with bandwidth 4 kHz, it is required to down-convert the source signals' sample rate to 8 kHz for the transmission, since the HQ signals have typically been sampled at a sample rate of 44.1 kHz or 48 kHz.

Also, to digitally mix signals from CD-ROM with speech annotation, it is necessary to convert their sample rates to the same sample rate for the mixing, since the CD-ROM has a sample rate of 44.1 kHz, while speech typically has a sample rate of 8 kHz. While it is possible to convert both signals into analog for mixing in the analog domain, it has been quite expensive in the analog domain due to the need for DAC and ADC, not to mention the attendant distortion problems.

Further, to digitally store the digitized speech signals on a PC for later processing, SRC is also needed, due to the difference in sample rates.

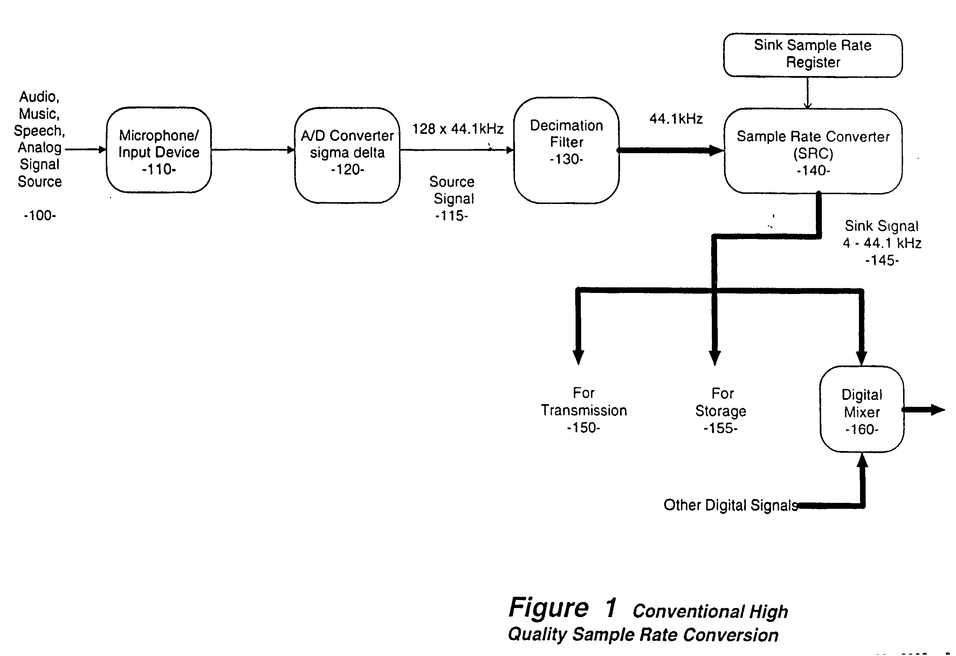

Figure 1 illustrates a conventional SRC for HQ audio signals. Such a system may include a mixer or microphone 110 for receiving analog source signals 100 such as music or speech, the received signals are then converted into an oversampled digital form by a sigma-delta analog/digital converter (ADC) 120. The digital signals are then applied to a decimation filter 130 for converting its sample rate to, e.g. 44.1 kHz, before they are applied to the SRC 140 to down convert its sample rate to a range between 4 and 44.1 kHz. The resulting signals 145 can then be transmitted through a telephone link 150, stored in a permanent memory, or storage disk 155 or mixed with other source signals 160.

But the conventional system is quite costly both in memory and computation cycle requirements in order to be able to convert from 44.1 down to 4 or 8 kHz, since this is a down conversion factor of more than 11 and 5, respectively. Since the required resources for the SRC both in memory and computations are proportional to the down sample ratio of the SRC, it is thus desirable to have a much more efficient implementation than the conventional approach.

References which represent the general state of the art include U.S. Pat. No. 5,157,395 which describes an analog-to-digital converter employing a delta-sigma modulator. The delta-sigma modulator has an output filtered by a digital filter section which includes a first fixed decimation filter, a variable decimation filter section, and an output filter section having a fixed decimation ratio. The variable decimation filter section includes a FIR filter that has data processed therethrough with different sampling rates.

A second reference representative of the general state of the art is provided by A. Y. Kwentus et. al. in "Application of Filter Sharpening to Cascaded Integrator-Comb Decimation Filters," IEEE Transactions on Signal Processing, US IEEE, Inc. New York, vol. 45, no. 2, February 1, 1997, pgs 457-467, XP000722539. This reference presents a new architecture for high order decimation filters which combines a cascaded integrated-comb multirate filter structure with filter sharpening techniques to improve the filter's passband response.

### SUMMARY OF THE INVENTION

Therefore, it is an object of the present invention to efficiently perform decimation sample rate conversion for high quality audio signals.

It is also an object of the present invention to perform decimation sample rate conversion with reduced computation cycles and RAM requirements.

The above objects of the invention are achieved by a method and a system according to claims 1 and 4 respectively.

A system for decimating a source signal with a source sample rate by a non-integer ratio to a sink signal with a sink sample rate is disclosed. The system first determines a decimation factor based on the ratio of the source sample rate to the sink sample rate. The system then decimates the source signal by the decimation factor to an intermediate ("IM") signal with an IM sample rate which is larger than the sink sample rate. The IM signal is then applied to a sample-rate converter to down-convert to the sink signal with the sink sample rate, using a factor between only 1 and 2.

### BRIEF DESCRIPTION OF THE DRAWINGS

**Figure 1** is a simplified block diagram of a conventional high-quality sample rate conversion system.
**Figure 2** is a simplified block diagram of the distributed sample rate conversion system in accordance with the present invention.

### DETAILED DESCRIPTION OF THE PREFERRED EMBODIMENTS

A method and system for distributed decimation sample rate conversion is disclosed. This embodiment has been developed for implementation as an integrated circuit for use with digital audio equipment. It should be understood by those skilled in the art that modifications may be made to optimize the sample rate converter for different applications and systems. The degrees of accuracy for the integrator, differentiator, FIR halfband filters are factors among others which can be optimized for a given application.

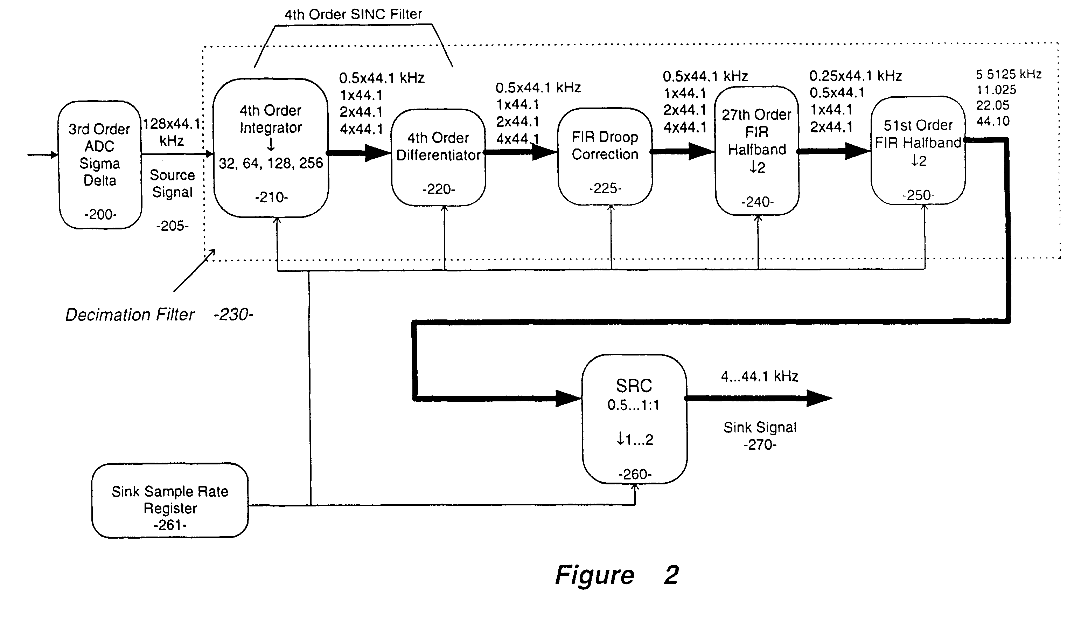

Reference is made to Figure **2**, where a simplified block diagram of the distributed decimation sample rate conversion in accordance with the present invention is shown. The individual functional blocks will be described as follows. The analog/digital converter 200 (ADC) is a third-order sigma delta converter for converting an analog input signal into an oversampled bit stream. Currently, the signals are oversampled at 128 x 44.1 kHz (= 5.6448 MHz).

After the ADC 200, the source signals are applied to the decimation filter 230 for noise filtering and decimation. The decimation filter block 230 has the following components: 4^{th}-order integrator 210, 4^{th}-order differentiator 220, finite impulse response (FIR) droop correction unit 225, 27^{th}-order FIR halfband filter 240, 51^{st}-order FIR halfband filter 250.

The integrator 210 and the differentiator 220, which together constitute a 4^{th}-order SINC filter, decimate the oversampled source signals from its sample rate of 128x44.1 kHz down to 0.5x44.1 kHz, 1x44.1 kHz, 2x44.1 kHz and 4x44.1 kHz, with a decimation factor of 256, 128, 64 and 32, respectively. The selection of the decimation factor is based on information transmitted from a programmable register 261, which stores the sink sample rate information. As will be described, the decimation factor is chosen such that the resulting sample rate after the decimation filter 230 is in the range between 1- and 2-times the sink sample rate.

After the integrator 210 and the differentiator 220, the signals are applied to an FIR droop correction unit 225. The droop correction is to correct the attenuation of high frequencies introduced by the integrator 210 and the differentiator 220.

The signals after the droop correction unit 225 are applied to two (2) FIR halfband filters 240, 250, which will decimate the signals by a factor 2 in each. Currently, the first halfband filter 240 is of the 27th-order and the second halfband filter 250 is of the 51 st-order.

The intermediate ("IM") signals after the second halfband filter 250 can have a sample rate at any of 5.5125 kHz, 11.025 kHz, 22.05 kHz and 44.10 kHz, depending on the decimator factor used by the integrator 210. Note that these sample rates are still a power-of-2 fraction of the source sample rate of 128x44.1 kHz, i.e. 2⁻¹⁰, 2⁻⁹, 2⁻⁸ and 2⁻⁷ of 128x44.1 kHz, respectively.

To prepare the IM signal for digital mixing or transmission in multimedia applications, it will be necessary to be able to convert the sample rate to a range between 4 kHz and 44.1 kHz, using a sample-rate converter ("SRC") 260.

A programmable register 261 stores the sink sample rate. The register sends out control information to the 4th order SINC filter, droop correction unit 225, the FIR halfband filters 240, 250 and the SRC 260, to indicate the range for the decimation by each unit.

With the distributed decimation described above, the SRC 260 only needs to perform a down conversion by a factor between 1 or 2, thereby conserving resources. The sink sample rate thereafter can be anywhere from 4 to 44.1 kHz, depending on the application and whether the sink samples are transmitted, stored, or mixed.

To illustrate the benefits and advantages of the present invention, Table 1 lists the effect of this distributed decimation sample rate conversion on the SRC factors, which can now be limited to a range between 1 and 2. Note that the required resources are proportional to the largest down sample factor. For example, at row (1), if the desired sink sample rate is 4 kHz, then the decimation factor of the SINC filter is set to be 256 to first decimate the source sample rate down to 0.5x44.1 kHz (=22.05 kHz).

After the factor 4 decimation by the halfband filters 240, 250, the SRC 260 only needs to down convert from 5.125 kHz to 4 kHz, using an SRC factor of only 1.28125. In the conventional methodology described above, the SRC will always have to down convert from 44.10 kHz after the FIR halfband (130) to 4 kHz - a conversion factor of more than 11! The decimation was not distributed to offload the burden on the SRC.

**Table 1**

| | Source Sample Rate [kHz] | SINC Deci. Factor | SINC Output Rate [kHz] | Halfband 1 Output Rate [kHz] | Halfband 2 Output Rate [kHz] | Sink Sample Rate Range [kHz] | SRC Factor | *Prior SRC Factor* |
|---|---|---|---|---|---|---|---|---|
| 1 | 128x44.1 | 256 *(32)** | 0.5x44.1 | 0.25x44.1 | 5.5125 *(44.1)** | b/w 4 and 5.5125 | 1...2 | *8*...*12* |
| 2 | 128x44.1 | 128 *(32)** | 1x44.1 | 0.5x44.1 | 11.025 *(44.1)** | b/w 5.5125 and 11.025 | 1...2 | *4*...*8* |
| 3 | 128x44.1 | 64 *(32)** | 2x44.1 | 1x44.1 | 22.05 *(44.1)** | b/w 11.025 and 22.05 | 1...2 | *2*...*4* |
| 4 | 128x44.1 | 32 *(32)** | 4x44.1 | 2x44.1 | 44.10 *(44.1)** | b/w 22.05 and 44.10 | 1...2 | *1*..*2* |

| | | | | | | | | |
|---|---|---|---|---|---|---|---|---|
| **(...)* indicates the values from a system without distributed decimation. | | | | | | | | |

Therefore, in accordance with the present invention, the system first considers the sink sample rate before the decimation factor of the SINC filter is set. Based on the range of the sink sample rate, the system chooses the decimation ratio accordingly.

The cost savings can be realized in the requirements of the random-access memory ("RAM"), which stores the data samples for the SRC. The distributed decimation can realize savings even with the requisite increase in a slightly larger integrator, since the size of the integrator 210 is proportional to log₂ of the SINC decimation factor, whereas the size of the SRC RAM is proportional to the SRC decimation factor.

Although only a few exemplary embodiments of this invention have been described in detail above, those skilled in the art will readily appreciate that many modifications are possible in the exemplary embodiments without materially departing from the novel teachings and advantages of this invention. Accordingly, all such modifications are intended to be included within the scope of this invention as defined in the following claims. In the claims, means-plus-function clauses are intended to cover the structures described herein as performing the recited function and not only structural equivalents but also equivalent structures. Thus although a nail and a screw may not be structural equivalents in that a nail employs a cylindrical surface to secure wooden parts together, whereas a screw employs a helical surface, in the environment of fastening wooden parts, a nail and a screw may be equivalent structures.

It should be noted that the objects and advantages of the invention may be attained by means of any compatible combination(s) particularly pointed out in the appended claims.

## Claims

1. A method of decimating a source signal (205) with a source sample rate to a sink signal (270) with a sink sample rate, comprising the steps of:
a) determining the ratio of the source sample rate to the sink sample rate;
b) determining a power-of-2 decimation factor based on the ratio;
c) decimating the source signal (205) by the power-of-2 decimation factor to an intermediate signal (IM) with an IM sample rate, where the IM sample rate is larger than the sink sample rate; and
d) down-converting the IM signal by a non-integer factor to the sink signal (270) with the sink sample rate by using a sample rate converter (260).

2. The method according to claim 1, wherein the IM sample rate is between about one and two times the sink sample rate.

3. The method according to claim 2, wherein the source signal (205) is an oversampled signal of an input signal.

4. A system for decimating a source signal (205) with a source sample rate by a non-integer ratio to a sink signal (270) with a sink sample rate, comprising:
means for determining a power-of-2 decimation factor based on the ratio of the source sample rate to the sink sample rate;
variable decimation filter means (230) for decimating the source signal (205) by the power-of-2 decimation factor to an intermediate signal (IM) with an IM sample rate which is larger than, or equal to, the sink sample rate, the variable decimation filter (230) means comprising a SINC filter; and
sample rate converter means (260) for down-converting the IM signal by a non-integer factor to the sink signal (270) with the sink sample rate.

5. The system according to claim 4, wherein the variable decimation filter means (230) decimates the source signal (205) to the IM signal with a sample rate between about one and two times the sink sample rate, using a programmable decimator factor.

6. The system according to claim 5 wherein the sample-rate converter means (260) converts using a conversion factor between 1 and 2.

7. The system according to claim 6, wherein the source signal (205) is oversampled by an oversampling factor, wherein the variable decimation filter (230) means comprises:
variable decimation integrator means (210) for integrating and decimating the source signal to generate an integration output, using one of the following decimation factors: 32, 64,128, and 256 based on the oversampling factor and the sink sample rate;
variable differentiator means (220) coupled to the variable integrator means (210) for differentiating the integration output to generate a differentiator output ;
FIR droop correction means (225) coupled to the variable differentiator means (220) for correcting highfrequency attenuation from the SINC filter to generate a corrected output;
first FIR halfband filter means (240) coupled to the FIR droop correction means (225) for down-converting the corrected output by a factor of 2; and
second FIR halfband filter means (250) coupled to the first FIR halfband filter means (240) for further down-converting by a factor of 2 the output signal of the first FIR halfband filter means, and for generating the IM signal with the IM sample rate.

## Patentansprüche

1. Verfahren des Dezimierens eines Quellensignals (205) mit einer Quellen-Abtastrate zu einem Senkensignal (270) mit einer Senken-Abtastrate, welches die Schritte aufweist:
a) Bestimmen des Verhältnisses der Quellen-Abtastrate zu der Senken-Abtastrate;
b) Bestimmen eines Zweierpotenz-Dezimationsfaktors basierend auf dem Verhältnis;
c) Dezimieren des Quellensignals (205) durch den Zweierpotenz-Dezimationsfaktor zu einem Zwischensignal (IM) mit einer IM-Abtastrate, wobei die IM-Abtastrate größer als die Senken-Abtastrate ist; und
d) Abwärtsumsetzen des IM-Signals durch einen nicht ganzzahligen Faktor zu dem Senkensignal (270) mit der Senken-Abtastrate unter Verwendung eines Abtastratenumsetzers (260).

2. Verfahren gemäß Anspruch 1, wobei die IM-Abtastrate zwischen ungefähr dem ein- bis zweifachen der Senken-Abtastrate liegt.

3. Verfahren gemäß Anspruch 2, wobei das Quellensignal (205) ein überabgetastetes Signal eines Eingangssignals ist.

4. System zum Dezimieren eines Quellensignals (205) mit einer Quellen-Abtastrate mit einem nicht ganzzahligen Verhältnis zu einem Senkensignal (270) mit einer Senken-Abtastrate, aufweisend:
Mittel zum Bestimmen eines Zweierpotenz-Dezimationsfaktors basierend auf dem Verhältnis der Quellen-Abtastrate zu der Senken-Abtastrate;
Variable-Dezimation-Filtermittel (230) zum Dezimieren des Quellensignals (205) durch den Zweierpotenz-Dezimationsfaktor zu einem Zwischensignal (IM) mit einer IM-Abtastrate, die größer als die oder gleich der Senken-Abtastrate ist, wobei das Variable-Dezimation-Filtermittel (230) einen SINC-Filter aufweist; und
Abtastratenumsetzer-Mittel (260) zum Abwärtsumsetzen des IM-Signals durch ein nicht ganzzahliges Verhältnis zu dem Senkensignal (270) mit der Senken-Abtastrate.

5. System gemäß Anspruch 4, wobei das Variable-Dezimation-Filtermittel (230) das Quellensignal (205) zu dem IM-Signal mit einer Abtastrate zwischen ungefähr dem ein- bis zweifachen der Senken-Abtastrate unter Verwendung eines programmierbaren Dezimationsfaktors dezimiert.

6. System gemäß Anspruch 5, wobei das Abtastratenumsetzer-Mittel (260) unter Verwendung eines Umsetzfaktors zwischen 1 und 2 umsetzt.

7. System gemäß Anspruch 6, wobei das Quellensignal (205) durch einen Überabtastfaktor überabgetastet ist, wobei das Variable-Dezimation-Filtermittel (230) aufweist:
Variable-Dezimation-Integrierermittel (210) zum Integrieren und Dezimieren des Quellensignals zum Erzeugen einer Integrationsausgabe unter Verwendung einer der folgenden Dezimationsfaktoren: 32, 64, 128 und 256 basierend auf dem Überabtastfaktor und der Senken-Abtastrate;
Variables Differenzierermittel (220), das mit dem variablen Integrierermittel (210) verbunden ist, zum Differenzieren der Integrationsausgabe, um eine Differenziererausgabe zu erzeugen;
FIR-Dachschräge-Korrekturmittel (225), das mit dem variablen Differenzierermittel (220) gekoppelt ist, zum Korrigieren hochfrequenter Dämpfung von dem SINC-Filter, um eine korrigierte Ausgabe zu erzeugen;
erstes FIR-Halbband-Filtermittel (240), das mit dem FIR-Dachschräge-Korrekturmittel (225) gekoppelt ist, zum Abwärtsumsetzen der korrigierten Ausgabe mit einem Faktor 2; und
zweites FIR-Halbband-Filtermittel (250), das mit dem ersten FIR-Halbband-Filtermittel (240) zum weiteren Abwärtsumsetzen mit einem Faktor 2 des Ausgabesignals des ersten FIR-Halbband-Filtermittels und zum Erzeugen des IM-Signals mit der IM-Abtastrate gekoppelt ist.

## Revendications

1. Procédé de décimation d'un signal source (205) avec une fréquence d'échantillonnage source vers un signal cible (270) avec une fréquence d'échantillonnage cible, comprenant les étapes consistant à :
a) déterminer le rapport de la fréquence d'échantillonnage source sur la fréquence d'échantillonnage cible ;
b) déterminer un facteur de décimation puissance de 2 en se basant sur le rapport ;
c) décimer le signal source (205) par le facteur de décimation puissance de 2 vers un signal intermédiaire IM avec une fréquence d'échantillonnage IM, où la fréquence d'échantillonnage IM est supérieure à la fréquence d'échantillonnage cible ; et
d) abaisser le signal IM par un facteur non entier au signal cible (270) avec la fréquence d'échantillonnage cible en utilisant un convertisseur de fréquence d'échantillonnage (260).

2. Procédé selon la revendication 1, dans lequel la fréquence d'échantillonnage IM est comprise entre une et deux fois la fréquence d'échantillonnage cible environ.

3. Procédé selon la revendication 2, dans lequel le signal source (205) est un signal suréchantillonné d'un signal d'entrée.

4. Système de décimation d'un signal source (205) avec une fréquence d'échantillonnage source par un rapport non entier à un signal cible (270) avec une fréquence d'échantillonnage cible, comprenant :
des moyens pour déterminer un facteur de décimation puissance de 2 en se basant sur le rapport de la fréquence d'échantillonnage source sur la fréquence d'échantillonnage cible ;
des moyens de filtre de décimation variables (230) pour décimer le signal source (205) par le facteur de décimation puissance de 2 à un signal intermédiaire avec une fréquence d'échantillonnage IM qui est supérieure ou égale à la fréquence d'échantillonnage cible, les moyens de filtre de décimation variables (230) comprenant un filtre SINC ; et
des moyens convertisseurs de fréquence d'échantillonnage (260) pour abaisser le signal IM par un facteur non entier au signal cible (270) avec la fréquence d'échantillonnage cible.

5. Système selon la revendication 4, dans lequel les moyens de filtre de décimation variables (230) déciment le signal source (205) au signal IM avec une fréquence d'échantillonnage entre une et deux fois la fréquence d'échantillonnage cible environ, en utilisant un facteur de décimation programmable.

6. Système selon la revendication 5, dans lequel les moyens convertisseurs de fréquence d'échantillonnage (260) assurent la conversion en utilisant un facteur de conversion entre 1 et 2.

7. Système selon la revendication 6, dans lequel le signal source (205) est suréchantillonné par un facteur de suréchantillonnage, dans lequel les moyens de filtre de décimation variables (230) comprennent :
des moyens intégrateurs de décimation variable (210) pour intégrer et décimer le signal source pour générer une sortie d'intégration, en utilisant un des facteurs de décimation suivants : 32, 64, 128 et 256 en se basant sur le facteur suréchantillonné et la fréquence d'échantillonnage cible ;
des moyens différentiateurs variables (220) couplés aux moyens intégrateurs variables (210) pour différencier la sortie d'intégration afin de générer une sortie de différentiation ;
des moyens de correction d'inclinaison de FIR (225) couplés aux moyens différentiateurs variables (220) pour corriger une atténuation haute-fréquence provenant du filtre SINC pour générer une sortie corrigée ;
des premiers moyens de filtre demi-bande FIR (240) couplés aux moyens de correction d'inclinaison de FIR (225) pour abaisser la sortie corrigée par un facteur de 2 ; et
des seconds moyens de filtre demi-bande FIR (250) couplés aux premiers moyens de filtre demi-bande FIR (240) pour abaisser en outre par un facteur de 2 le signal de sortie des premiers moyens de filtre demi-bande FIR, et pour générer le signal IM avec la fréquence d'échantillonnage IM.
